(19)

Europäisches Patentamt

European Patent Office

Office européen des brevets

(11) **EP 4 667 955 A1**

(12) **EUROPEAN PATENT APPLICATION**

(43) Date of publication:
**24.12.2025  Bulletin 2025/52**

(21) Application number: **25181399.4**

(22) Date of filing: **06.06.2025**

(51) International Patent Classification (IPC):
*G01R 31/367* (2019.01)      *G01R 31/3828* (2019.01)
*G01R 31/3842* (2019.01)      *G01R 31/388* (2019.01)

(52) Cooperative Patent Classification (CPC):
**G01R 31/367; G01R 31/3828; G01R 31/3842;**
**G01R 31/388; Y02E 60/10**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority:  **20.06.2024  CN 202410807464**

(71) Applicant: **Autel Robotics Co., Ltd.**
**Shenzhen, Guangdong 518055 (CN)**

(72) Inventor: **Qin, Wei**
**Taoyuan Sub-district, Nanshan District,**
**Shenzhen,**
**Guangdong, 518055 (CN)**

(74) Representative: **Gulde & Partner**
**Patent- und Rechtsanwaltskanzlei mbB**
**Berliner Freiheit 2**
**10785 Berlin (DE)**

(54) **BATTERY LEVEL VERIFICATION METHOD, CONTROLLER, BATTERY APPARATUS, AND DRONE**

(57)    Embodiments of the present invention relate to the field of battery technologies, and specifically, to a battery level verification method, a controller, a battery apparatus, and a drone. The battery level verification method includes: obtaining battery sampling data and a first battery level; determining a target battery level according to the battery sampling data; generating first battery level verification information according to the target battery level and the first battery level; controlling, if first battery level verification information is used to indicate that the first battery level is unreliable, a coulometer to perform a reset operation, so that the coulometer calculates, in a reset state, a second battery level of a battery according to the battery sampling data; and generating second battery level verification information according to the second battery level and the target battery level. According to this embodiment, reliability of a battery level estimated by a coulometer can be verified based on a battery status, and misjudgment by the coulometer due to failure to respond in time can be avoided, thereby improving reliability of battery level verification and helping the coulometer to accurately and reliably display the battery level.

FIG. 1

**Description**

**BACKGROUND**

**Technical Field**

Embodiments of the present invention relate to the field of battery technologies, and specifically, to a battery level verification method, a controller, a battery apparatus, and a drone.

**Related Art**

A battery is generally used on a drone to supply power to electric modules such as a flight control module and a motor on the drone. To ensure normal use of the drone, a remaining capacity of the battery needs to be accurately and reliably estimated. In the related art, a battery level metering chip is usually used to estimate a remaining capacity of a battery. The remaining capacity of the battery estimated by the battery level metering chip in normal use of the battery is relatively accurate. However, during abnormal use of the battery or when the battery is used for a long time, there is a deviation from a status of the battery in normal use. Such a deviation affects accuracy of estimating the remaining capacity of the battery by the battery level metering chip. If an inaccurate remaining capacity of the battery is still used for display, user experience is affected and a drone crash may even be caused.

**SUMMARY**

An objective of embodiments of the present invention is to provide a battery level verification method, a controller, a battery apparatus, and a drone, to resolve a technical problem in the related art of inaccurate estimation of a remaining capacity of a battery by a battery level metering chip.

According to a first aspect, an embodiment of the present invention provides a battery level verification method, applied to a battery apparatus, where the battery apparatus includes a battery, a battery sampling module, a coulometer, and a controller, the battery sampling module being electrically connected to the battery and the coulometer separately, and the coulometer being further electrically connected to the controller, and the method includes:

> obtaining battery sampling data and a first battery level, the battery sampling data being collected by the battery sampling module from the battery, and the first battery level being calculated by the coulometer in a non-reset state according to the battery sampling data;
> determining a target battery level according to the battery sampling data;
> generating first battery level verification information according to the target battery level and the first battery level;
> controlling, if the first battery level verification information is used to indicate that the first battery level is unreliable, the coulometer to perform a reset operation, so that the coulometer calculates, in a reset state, a second battery level of the battery according to the battery sampling data; and
> generating second battery level verification information according to the second battery level and the target battery level.

Optionally, the battery sampling data includes a battery current and battery status parameters, and the determining a target battery level according to the battery sampling data includes:

> determining whether the battery current is stable within a target current interval; and
> determining the target battery level according to the battery status parameters if the battery current is stable within the target current interval.

Optionally, the target current interval is one of at least two current intervals, different current intervals correspond to different preset databases, and the determining the target battery level according to the battery status parameters includes:

> determining a target database corresponding to the target current interval in a plurality of preset databases; and
> finding a corresponding reference battery level in the target database according to the battery status parameters as the target battery level.

Optionally, the generating first battery level verification information according to the target battery level and the first battery level includes:

calculating a first battery level difference between the first battery level and the target battery level; and generating the first battery level verification information according to the first battery level difference and a first preset battery level threshold.

Optionally, the generating second battery level verification information according to the second battery level and the target battery level includes:

calculating a second battery level difference between the second battery level and the target battery level; and generating the second battery level verification information according to the second battery level difference and a second preset battery level threshold.

Optionally, the battery status parameters include a battery voltage and a battery temperature, and the method further includes:

generating an alarm signal if the second battery level verification information is used to indicate that the second battery level is unreliable; or generating a predicted battery level value according to a battery cycle count, the battery voltage, the battery temperature, the second battery level difference, and the second battery level.

Optionally, the generating a predicted battery level value according to a battery cycle count, the battery voltage, the battery temperature, the second battery level difference, and the second battery level includes:

determining a battery level calibration coefficient according to the battery voltage, the battery temperature, the battery cycle count, and the second battery level difference; and generating the predicted battery level value according to the battery level calibration coefficient and the second battery level.

Optionally, the determining a battery level calibration coefficient according to the battery voltage, the battery temperature, the battery cycle count, and the second battery level difference includes:

determining a first calibration coefficient according to the battery voltage, the battery temperature, and the battery cycle count; determining a second calibration coefficient according to the second battery level difference; and determining the battery level calibration coefficient according to the first calibration coefficient and the second calibration coefficient.

Optionally, the determining a first calibration coefficient according to the battery voltage, the battery temperature, and the battery cycle count includes:

normalizing the battery voltage, the battery temperature, and the battery cycle count respectively to obtain a normalized voltage value, a normalized temperature value, and a normalized count value; calculating a weighted value according to the normalized voltage value, a first weight coefficient, the normalized temperature value, a second weight coefficient, the normalized count value, and a third weight coefficient; and determining the first calibration coefficient according to the weighted value.

Optionally, the first calibration coefficient corresponds to a fourth weight coefficient, the second calibration coefficient corresponds to a fifth weight coefficient, and the determining the battery level calibration coefficient according to the first calibration coefficient and the second calibration coefficient includes:

calculating a coefficient difference between the first calibration coefficient and the second calibration coefficient; determining a correction factor according to the coefficient difference; correcting the fourth weight coefficient and the fifth weight coefficient according to the correction factor to obtain a corrected fourth weight coefficient and a corrected fifth weight coefficient; and determining the battery level calibration coefficient according to the first calibration coefficient, the corrected fourth weight coefficient, the second calibration coefficient, and the corrected fifth weight coefficient.

According to a second aspect, an embodiment of the present invention provides a controller, including:

at least one processor; and

a memory communicatively connected to the at least one processor, where

the memory stores instructions executable by the at least one processor, and the instructions are executed by the at least one processor to enable the at least one processor to perform the battery level verification method described above.

According to a third aspect, an embodiment of the present invention provides a battery apparatus, including:

a battery;

a battery sampling module, electrically connected to the battery and configured to sample battery data of the battery;

a coulometer, electrically connected to the battery sampling module and configured to calculate a battery level of the battery according to the battery data; and

the controller described above, where the controller is electrically connected to the coulometer.

According to a fourth aspect, an embodiment of the present invention provides a drone, including the battery apparatus described above.

A battery level verification method provided in the embodiments of the present invention is applied to a battery apparatus. The battery apparatus includes a battery, a battery sampling module, a coulometer, and a controller. The battery sampling module is electrically connected to the battery and the coulometer separately. The coulometer is further electrically connected to the controller. The battery level verification method includes: obtaining battery sampling data and a first battery level, the battery sampling data being collected by the battery sampling module from the battery, and the first battery level being calculated by the coulometer in a non-reset state according to the battery sampling data; determining a target battery level according to the battery sampling data; generating first battery level verification information according to the target battery level and the first battery level; controlling, if the first battery level verification information is used to indicate that the first battery level is unreliable, the coulometer to perform a reset operation, so that the coulometer calculates, in a reset state, a second battery level of the battery according to the battery sampling data; and generating second battery level verification information according to the second battery level and the target battery level. On the one hand, this embodiment can verify, based on a battery status, reliability of a battery level estimated by a coulometer, thereby helping improve accuracy and reliability of battery level display. On the other hand, this embodiment can avoid misjudgment by the coulometer due to failure to respond in time, thereby improving reliability of battery level verification and helping further improve accuracy and reliability of battery level display.

## BRIEF DESCRIPTION OF THE DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.

FIG. 1 is a schematic structural diagram of a battery apparatus according to an embodiment of the present invention;

FIG. 2 is a schematic flowchart of a battery level verification method according to an embodiment of the present invention;

FIG. 3 is a schematic flowchart of S22 shown in FIG. 2;

FIG. 4 is a schematic flowchart of S221 shown in FIG. 3;

FIG. 5 is a schematic structural diagram of a battery level verification apparatus according to an embodiment of the present invention;

FIG. 6 is a schematic structural diagram of a first determining module shown in FIG. 5;

FIG. 7 is a schematic structural diagram of a first generation module shown in FIG. 5;

FIG. 8 is a schematic structural diagram of a first generation module shown in FIG. 5;

FIG. 9 is a schematic structural diagram of a battery level verification apparatus according to another embodiment of the present invention;

FIG. 10 is a schematic structural diagram of a battery level verification apparatus according to still another embodiment of the present invention;

FIG. 11 is a schematic structural diagram of a third generation module shown in FIG. 10; and

FIG. 12 is a schematic diagram of a hardware structure of a controller according to an embodiment of the present invention.

**DETAILED DESCRIPTION**

To make the objectives, technical solutions, and advantages of the present invention clearer and more comprehensible, the following further describes the present invention in detail with reference to the accompanying drawings and embodiments. It should be understood that the embodiments herein are provided for describing the present invention and not intended to limit the present invention. All other embodiments obtained by a person of ordinary skill in the art based on the embodiments of this application without creative efforts shall fall within the protection scope of this application.

It should be noted that, if there are no conflicts, the features in the embodiments of the present invention may be combined with each other and all fall within the protection scope of the present invention. In addition, although functional modules are divided in the schematic diagram of the apparatus or a logic sequence is shown in the flowchart, in some cases, the shown or described steps may be performed in a sequence different from the module division in the apparatus or the sequence in the flowchart. In addition, words such as "first", "second", and "third" used in the present invention do not limit data and an execution order, but are used only to distinguish the same items or similar items with basically the same functions and effects.

An embodiment of the present invention provides a drone. The drone includes a body and a battery apparatus. The body is provided with a battery compartment capable of accommodating the battery apparatus. The body includes a center body and a plurality of arms extending from the center body. The plurality of arms may be symmetrically disposed. A motor is fixedly mounted on one end of the arm far away from the center body. Rotor blades are mounted on the motor. The motor is configured to drive the rotor blades to rotate to enable the drone to take off. When the drone is running, the battery apparatus may supply power to any electric module such as the flight control module and the motor on the drone.

The drone may be any unmanned aerial vehicle of any suitable power-driven type, including, but not limited to, a fixed-wing drone, a rotary wing drone, an unmanned airship, a paraglider drone, a flapping-wing drone, or the like.

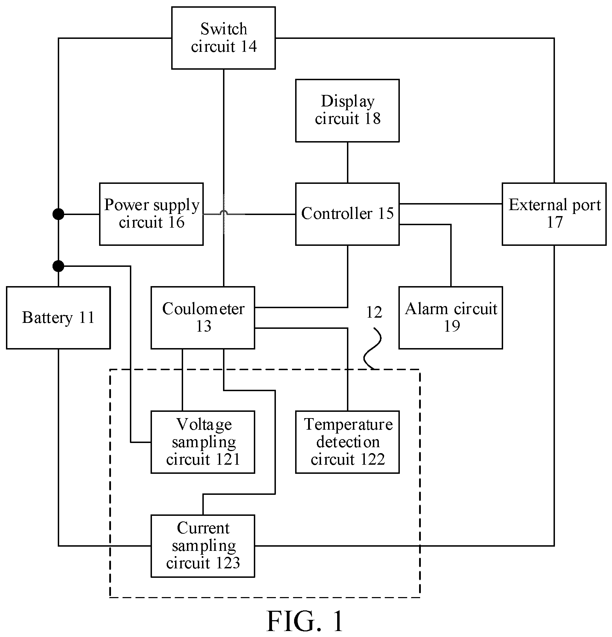

An embodiment of the present invention provides a battery apparatus. Referring to FIG. 1, the battery apparatus 100 includes a battery 11, a battery sampling module 12, a coulometer 13, a switch circuit 14, a controller 15, a power supply circuit 16, an external port 17, a display circuit 18, and an alarm circuit 19.

The battery 11 is an energy output source of the battery apparatus 100. The battery 11 may include one or more cells (cell cores). A plurality of cells may be connected together in series or parallel, to reach a required voltage or current. A voltage at two ends after the plurality of cells are connected in series or parallel is a voltage of the battery 11. One end after the plurality of cells are connected in series or parallel may be used as a positive terminal of the battery 11, and the other end after the plurality of cells are connected in series or parallel may be used as a negative terminal of the battery 11.

A voltage difference between a positive terminal and a negative terminal of a cell is referred to as a cell voltage. Different types of cells have different voltage characteristics. Common cell types include a lithium-ion battery, a nickel-metal hydride battery, a lead-acid battery, and the like. The lithium-ion battery usually has a relatively high cell voltage, usually 3.6 V to 3.7 V, while the nickel-metal hydride battery has a cell voltage of 1.2 V and the lead-acid battery has a cell voltage of 2 V.

In some embodiments, the cell is a lithium-ion battery (a lithium polymer battery). The lithium-ion battery has features of high energy density, smaller size, ultra-thinness, lightweight, high safety, and the like.

The battery sampling module 12 is electrically connected to the battery 11 and is configured to sample various battery data during current operation of the battery 11, such as a battery voltage, a battery current, or a battery temperature of the battery 11.

In some embodiments, as shown in FIG. 1, the battery sampling module 12 includes a voltage sampling circuit 121, a temperature detection circuit 122, and a current sampling circuit 123.

The voltage sampling circuit 121 is electrically connected to the battery 11 and is configured to sample the battery voltage of the battery 11. The voltage sampling circuit 121 may use any circuit type and structure to sample the battery voltage of the battery 11. For example, the circuit type includes an isolated type and a non-isolated type. The isolated type usually uses an isolation device to electrically isolate and sample a front-end signal. Commonly, transformer sampling, optocoupler sampling, hall sampling, and the like are used. The non-isolated type has no electrical isolation, and an input signal and an output signal share a same ground reference. Commonly, voltage divider sampling, direct sampling by an operational amplifier, and the like are used.

The temperature detection circuit 122 is in contact with the battery 11 and is configured to detect the battery temperature of the battery 11. The temperature detection circuit 122 may detect the battery temperature by using a thermistor whose resistance changes with temperature, the resistance of the thermistor having a correspondence, and then detect a voltage across the thermistor, the voltage across the thermistor also having a correspondence with the resistance of the thermistor, so that the battery temperature of the battery 11 can be subsequently calculated according to the voltage across the thermistor. The thermistor may be a positive temperature coefficient (PTC) thermistor, or may be a negative temperature coefficient (NTC) thermistor. A resistance of the PTC thermistor increases stepwise with an increase in a temperature of a resistor body. A higher temperature indicates a larger resistance. On the contrary, a resistance of the NTC thermistor decreases with an increase in a temperature of a resistor body.

The current sampling circuit 123 is electrically connected to the battery 11 and is configured to sample the battery current of the battery 11. The battery current may be a discharge current of the battery 11 or a charge current of the battery 11. The current sampling circuit 123 may use any circuit type and structure to sample the battery voltage of the battery 11. For example, the circuit type includes a hall type, a resistive type, or a capacitive type. For the hall type, the circuit may be formed by connecting a hall element and a feedback resistor in parallel, a current is converted into a voltage signal for output, and subsequently a value of the current is calculated according to the voltage signal. For the resistive type, a current may be caused to pass through a resistor and converted, by using Ohm's law, into a voltage signal for output, and subsequently a value of the current is calculated according to the voltage signal. For the capacitive type, a capacitor may be placed in the circuit, and a value of a current is calculated according to a time constant for charging and discharging the capacitor.

The coulometer 13 is electrically connected to the battery sampling module 12 and is configured to obtain battery sampling data such as a battery voltage, a battery current, or a battery temperature of the battery 11 from the battery sampling module 12, then calculate a battery level of the battery 11 according to the battery sampling data, and accumulate a battery cycle count of the battery 11 according to a capacity consumption status of the battery 11. The battery level is a remaining capacity of the battery 11, and is usually represented by a proportion of an available capacity in the battery to a nominal capacity. In practice, the coulometer 13 usually collects statistics on a discharge capacity of the battery 11 during discharging of the battery 11. When an accumulated discharge capacity of the battery 11 reaches 80%, it may be considered that the battery 11 completes one cycle. Therefore, the coulometer 13 increases a current battery cycle count by 1 to obtain and store an updated battery cycle count. It may be understood that the battery cycle count may reflect an aging degree of the battery to some extent, that is, a larger battery cycle count indicates a shorter service life of the battery.

The coulometer 13 may be any coulometer that can implement a battery level metering function, and may use any implementation method such as an open circuit voltage method and a coulomb counting method. A principle of the open circuit voltage method is to estimate a remaining capacity of a battery according to an open circuit of the battery. Although the method is to measure an open circuit voltage of the battery, in practice, the remaining capacity of the battery needs to be obtained basically during operation of the battery. Therefore, only a terminal voltage of the battery can be usually obtained through testing, and then the remaining capacity of the battery is estimated by using the terminal voltage of the battery. The terminal voltage V of the battery is $V = OCV - IR$, where OCV is the open circuit voltage of the battery, I is a battery current, and R is an internal resistance of the battery. It may be understood that, a larger battery current I and a larger internal resistance R of the battery indicate a larger difference between the terminal voltage V and the open circuit voltage OCV of the battery, and a larger error in an estimated battery state of charge and battery level. A principle of the coulomb counting method is to connect a current sense resistor to a charge and discharge circuit of a battery. In the method, a full-charge maximum capacity of the battery is usually obtained first, then a discharge current in a discharge process is integrated over time to obtain a discharge capacity, and a remaining capacity can be obtained by subtracting the discharge capacity from the full-charge capacity. In the method, a complete discharge period is usually needed to learn to determine a maximum capacity of the battery. Theoretically, update is performed during full discharging of the battery. However, in practice, some battery capacity needs to be reserved due to the need to perform some operations such as powering off.

The switch circuit 14 is electrically connected to the battery 11 and the coulometer 13 separately and is configured to switch on or switch off a charge and discharge circuit of the battery 11 under control of the coulometer 13, to control charging and discharging of the battery 11. The switch circuit 14 may be disposed at a positive terminal of the battery 11 to implement positive terminal control, or may be disposed at a negative terminal of the battery 11 to implement negative terminal control. The switch circuit 14 may include any suitable switch device or electronic switch transistor such as a metal-oxide-semiconductor (MOS) transistor.

The controller 15 is electrically connected to the coulometer 13 and configured to communicate with the coulometer 13 and in a communication process, send various data such as a reset instruction to the coulometer 13 or receive various data such as a battery voltage, a battery current, a battery temperature, a battery level, and a battery cycle count of the battery 11 that are sent by the coulometer 13.

The power supply circuit 16 is electrically connected to the battery 11 and the controller 15 separately and is configured to supply power to the controller 15 after the battery voltage of the battery 11 is bucked and stabilized. The power supply circuit 16 may include any suitable type of voltage regulator circuit, for example, a linear voltage regulator circuit or a switching voltage regulator circuit.

The external port 17 is electrically connected to the switch circuit 14 and the controller 15 separately and is configured to connect to a charger or an electrical load. When the external port 17 is in a plugged-in state with the charger and the switch circuit 14 is in a turned-on state, the charger may charge the battery 11 through the external port 17. When the external port 17 is in a plugged-in state with the electrical load and the switch circuit 14 is in a turned-on state, the battery 11 may be discharged to the electrical load through the external port 17 for use.

The display circuit 18 is electrically connected to the controller 15 and is configured to display information such as a battery level of the battery 11 under control of the controller 15.

The alarm circuit 19 is electrically connected to the controller 15 and is configured to perform an alarm operation under control of the controller 15. The alarm operation includes any operation that can remind a user, for example, making a sound and lighting up an indicator.

It may be understood that the display circuit 18 may further integrate a display function and an alarm function. For example, an alarm operation may be performed under the control of the controller 15. The alarm operation may be displaying text or a pattern to remind a user. In this case, the alarm circuit 19 may be omitted.

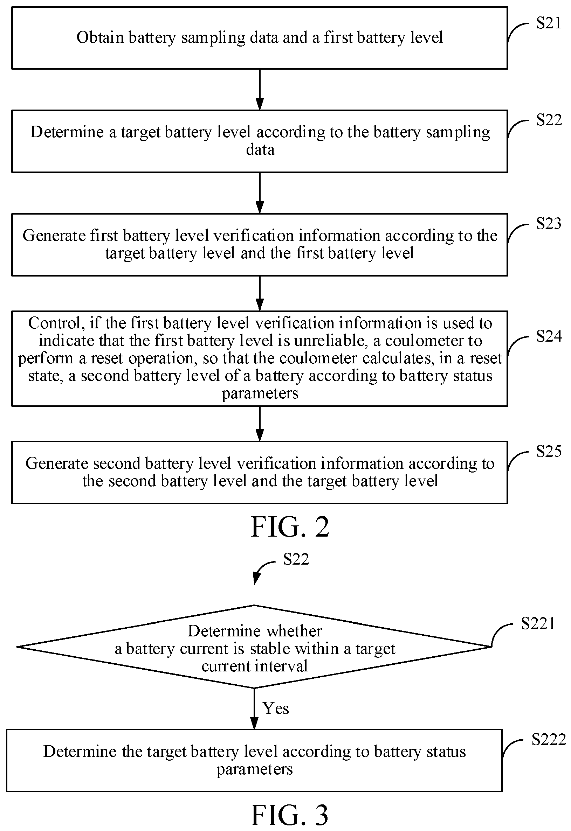

An embodiment of the present invention provides a battery level verification method. Referring to FIG. 2, the method includes:

S21: Obtain battery sampling data and a first battery level, the battery sampling data being collected by a battery sampling module from a battery, and the first battery level being calculated by a coulometer in a non-reset state according to the battery sampling data.

In this step, the battery sampling data is data collected by the battery sampling module from the battery. The data may be used to indicate a current working status or health degree of the battery. For example, the battery sampling data may include a battery current, a battery voltage, a battery temperature, or the like. A reset state of the coulometer may be controlled by a controller. When the coulometer needs to be reset, the controller may send a reset instruction to the coulometer, so that the coulometer performs a reset operation according to the reset instruction. The non-reset state refers to a state in which the coulometer does not currently perform a reset operation. In the non-reset state, the coulometer may calculate a battery level of the battery according to the battery sampling data such as the battery voltage, the battery current, or the battery temperature by using any suitable battery level metering method such as an open circuit voltage method or a coulomb counting method. The battery level is the first battery level.

S22: Determine a target battery level according to the battery sampling data.

In this step, the target battery level is a level used to verify whether the first battery level is reliable. The controller may determine the target battery level according to the battery sampling data by using any suitable method. For example, the controller may calculate the target battery level according to the battery sampling data according to a preconfigured algorithm, or the controller may search a preset database according to the battery sampling data. The preset database stores a relationship between the battery sampling data and a reference battery level. The reference battery level refers to an empirical battery level value or a test battery level value of the battery in a current state. The controller may find a reference battery level corresponding to the battery sampling data in the preset database, and determine the reference battery level as a target battery level. The preset database may be configured according to an actual requirement. For example, the preset database is represented by using the following Table 1:

Table 1

| Battery voltage | Battery temperature | Range of battery cycle count | Reference battery level |
|---|---|---|---|
| V1 | T1 | N1 | Q1 |
| | | N2 | Q2 |
| | | ... | ... |
| | T2 | N1 | Q3 |
| | | N2 | Q4 |
| | | ... | ... |
| | ... | ... | ... |
| V2 | T1 | N1 | Q5 |
| | | N2 | Q6 |
| | | ... | ... |
| | T2 | N1 | Q7 |
| | | N2 | Q8 |
| | | ... | ... |
| | ... | ... | ... |
| ... | ... | ... | ... |

In some embodiments, the battery sampling data includes a battery current. It may be understood that when the battery current is unstable, for example, when a battery circuit fluctuates greatly in a short period of time, inconsistency between battery status data such as the battery voltage and a current actual situation is easily caused, and consequently, the target battery level determined by the controller is also inconsistent with the current actual situation. To avoid such a problem, in some embodiments, the controller may determine the target battery level according to the battery sampling data only when detecting that the battery current is stable. This can ensure that battery status data, such as the battery voltage, obtained by the coulometer from the battery is more consistent with the current actual situation and is more accurate and reliable, thereby ensuring that the target battery level is more accurately and reliably determined subsequently.

In some embodiments, referring to FIG. 3, S22 includes:

S221: Determine whether a battery current is stable within a target current interval.

In this step, the target current interval is a preset current interval matching the battery current, the preset current interval is a current range value, and the current range value may be configured according to an actual requirement. There may be one or more preset current intervals. For example, when a different electrical load is plugged into an external port, the battery current is generally different. When the battery current is stable, the battery current may be stable in a current interval with relatively small currents or may be stable in a current interval with relatively large currents. Therefore, in some embodiments, the controller may adaptively determine stability of the battery current according to different electrical loads. This helps ensure that the controller subsequently more accurately and reliably determines the target battery level.

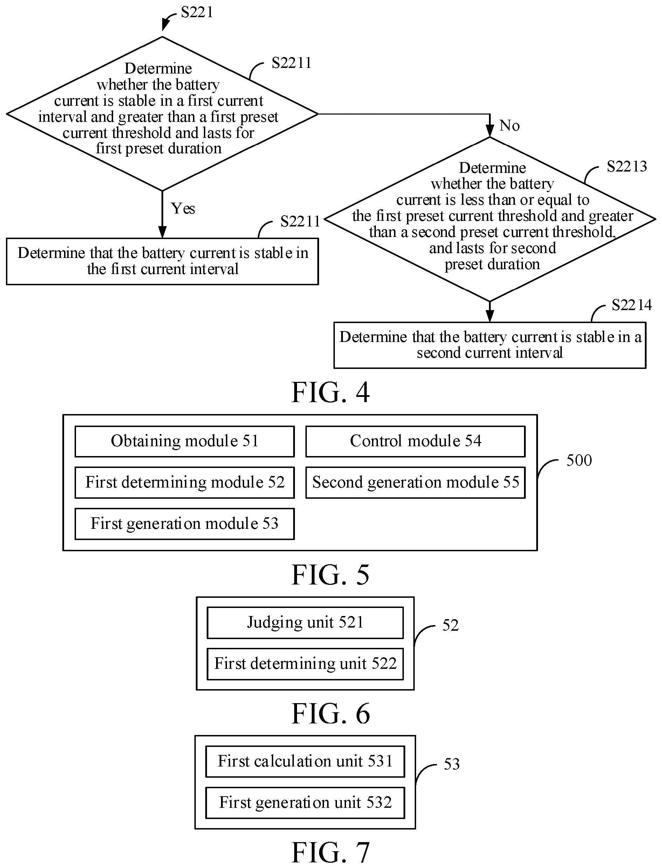

In some embodiments, the preset current interval includes a first current interval and a second current interval, and a current in the first current interval is less than or equal to a current in the second current interval. Referring to FIG. 4, S221 includes:

S2211: Determine whether the battery current is greater than a first preset current threshold and lasts for first preset duration.

In this step, if the battery current is continuously greater than a particular current within a particular period of time, it indicates that the battery current is stable within a current interval greater than the current.

S2212: If the battery current is greater than the first preset current threshold and lasts for the first preset duration, determine that the battery current is stable in a first current interval.

In this step, the first current interval is a current interval in which the current is greater than the first preset current threshold. When the battery current is greater than the first preset current threshold and lasts for the first preset duration, the first current interval is the target current interval.

S2213: If the battery current is greater than the first preset threshold and does not last for the first preset duration, or is less than or equal to the first preset threshold, determine whether the battery current is less than or equal to the first preset current threshold and greater than a second preset current threshold, and lasts for second preset duration.

In this step, if the battery current is greater than the first preset threshold and does not last for the first preset duration or is less than or equal to the first preset threshold, the battery current may be stable in another current interval. If the battery current is continuously less than or equal to the first preset current threshold and greater than the second preset current threshold within a particular period of time, it indicates that the battery current is stable in a current interval less than or equal to the first preset current threshold and greater than the second preset current threshold.

S2214: If the battery current is less than or equal to the first preset current threshold and greater than the second preset current threshold, and lasts for the second preset duration, determine that the battery current is stable in a second current interval.

In this step, the second current interval is a current interval in which a current is less than or equal to the first preset current threshold and greater than the second preset current threshold. When the battery current is less than or equal to the first preset current threshold and greater than the second preset current threshold, and lasts for the second preset duration, the second current interval is the target current interval.

It may be understood that, if the battery current is not stable in the first current interval or the second current interval, it indicates that the battery current unstable, and it is not suitable to verify the battery level of the battery. Therefore, the controller may directly stop verifying the battery level of the battery.

S222: Determine the target battery level according to battery status parameters if the battery current is stable within the target current interval.

In this step, the battery sampling data further includes battery status parameters, and the battery status parameters include a battery voltage, a battery temperature, a battery cycle count, or the like.

In some embodiments, different current intervals correspond to different preset databases, and each preset database stores a correspondence between battery status data and a reference battery level. The controller may determine a target database corresponding to the target current interval in a plurality of preset databases, and find a corresponding reference battery level in the target database according to the battery status parameters as the target battery level.

For example, in each preset database, different combinations of a battery voltage and a battery temperature correspond to different reference battery levels. The controller finds, from the target database according to the battery voltage and the battery temperature, a reference battery level corresponding to a unique combination of the battery voltage and the battery temperature, and determines the reference battery level as the target battery level.

Therefore, this embodiment can adapt to different electrical loads by configuring different preset databases for different battery currents, and can ensure accuracy of the target battery level regardless of which electrical load is plugged in.

It may be understood that in some cases, when a change in an electrical load does not greatly affect accuracy of battery level verification, different current intervals may correspond to a same preset database. For example, as described above, the first current interval and the second current interval correspond to a same preset database.

Because the battery level of the battery is affected not only by the battery status parameters such as the battery voltage and the battery temperature, but also by the battery cycle count, in some embodiments, the controller may further determine the target battery level with reference to the battery status parameters and the battery cycle count. As shown in the foregoing Table 1, the preset database may further configure different reference battery levels corresponding to different combinations of the battery voltage, the battery temperature, and the battery cycle count. The controller finds, from the target database according to the battery voltage, the battery temperature, and the battery cycle count, a reference battery level corresponding to a unique combination of the battery voltage, the battery temperature, and the battery cycle count, and determines the reference battery level as the target battery level.

S23: Generate first battery level verification information according to the target battery level and the first battery level.

In this step, the first battery level verification information is information used to indicate whether the first battery level is reliable or unreliable. The controller may generate corresponding first battery level verification information according to a deviation degree between the first battery level and the target battery level. For example, when the first battery level has a relatively small deviation from the target battery level, the first battery level verification information generated by the controller may be used to indicate that the first battery level is reliable. In this case, the controller may end a battery level verification procedure and control a battery apparatus to be in a standby mode. When the first battery level has a relatively large deviation from the target battery level, the first battery level verification information generated by the controller may be used to indicate that the first battery level is unreliable. In this case, the controller needs to further verify the battery level.

In some embodiments, the controller calculates a first battery level difference between the first battery level and the target battery level, and generates the first battery level verification information according to the first battery level difference and a first preset battery level threshold.

For example, first, the controller subtracts the target battery level from the first battery level to obtain a first battery level difference, then, takes an absolute value of the first battery level difference, and determines whether the absolute value of the first battery level difference is less than or equal to the first preset battery level threshold. If the absolute value of the first battery level difference is less than or equal to the first preset battery level threshold, the controller may generate the first battery level verification information used to indicate that the first battery level is reliable. If the absolute value of the first battery level difference is greater than the first preset battery level threshold, the controller may generate the first battery level verification information used to indicate that the first battery level is unreliable.

S24: Control, if the first battery level verification information is used to indicate that the first battery level is unreliable, the coulometer to perform a reset operation, so that the coulometer calculates, in a reset state, a second battery level of the battery according to the battery status parameters.

In this step, when the first battery level verification information is used to indicate that the first battery level is unreliable, it cannot be considered that the first battery level is definitely unreliable. For example, when a special case occurs, for example, when an electrical load changes and the coulometer fails to respond in time, the first battery level read by the controller from the coulometer may not be accurate at this time, that is, there is a possibility of misjudgment in this case. To avoid misjudgment, when the first battery level verification information generated by the controller is used to indicate that the first battery level is unreliable, the controller may send a reset instruction to the coulometer, and the coulometer is in a reset state after completing a reset operation according to the reset instruction. Therefore, the coulometer calculates, in the reset state, the battery level of the battery again according to the battery sampling data, and the battery level is the second battery level.

S25: Generate second battery level verification information according to the second battery level and the target battery level.

In this step, the second battery level verification information is information used to indicate whether the first battery level is reliable or unreliable. The controller may read the second battery level from the coulometer, and generate corresponding second battery level verification information according to a deviation degree between the first battery level and the target battery level. For example, when the second battery level has a relatively small deviation from the target battery level, the second battery level verification information generated by the controller may be used to indicate that the first battery level is reliable. In this case, the controller may end a battery level verification procedure and control a battery apparatus to be in a standby mode. When the second battery level has a relatively large deviation from the target battery level, the second battery level verification information generated by the controller may be used to indicate that the second battery level is unreliable. **In** this case, the controller may perform a preset operation.

In some embodiments, the controller calculates a second battery level difference between the second battery level and the target battery level, and generates the second battery level verification information according to the second battery level difference and a second preset battery level threshold.

For example, first, the controller subtracts the target battery level from the second battery level to obtain a second battery level difference, then, takes an absolute value of the second battery level difference, and determines whether the absolute value of the second battery level difference is less than or equal to the second preset battery level threshold. If the absolute value of the second battery level difference is less than or equal to the second preset battery level threshold, the controller may generate the second battery level verification information used to indicate that the second battery level is reliable. If the absolute value of the second battery level difference is greater than the second preset battery level threshold, the controller may generate the second battery level verification information used to indicate that the second battery level is unreliable.

Therefore, on the one hand, this embodiment verifies, by using a target battery voltage matching a current battery state, reliability of a battery level estimated by a coulometer, and the battery level is displayed only when the battery level is considered to be reliable after the verification, thereby helping improve accuracy and reliability of battery level display. On the other hand, this embodiment can avoid misjudgment by the coulometer due to failure to respond in time, thereby improving reliability of battery level verification and helping further improve accuracy and reliability of battery level display.

In some embodiments, when the second battery level verification information is used to indicate that the second battery level is unreliable, it indicates that the battery level estimated by the coulometer is still unreliable after two verifications. In this case, the estimation by the coulometer may not be sufficiently accurate. Therefore, the controller may generate an alarm signal and output the alarm information to the alarm circuit, so that the alarm circuit performs an alarm operation in response to the alarm signal.

In some embodiments, when the second battery level verification information is used to indicate that the second battery level is unreliable, to avoid that the battery level cannot be normally displayed, the controller may further predict the battery level of the battery by using any suitable algorithm, to obtain a predicted battery level value, and control a display circuit to display the predicted battery level value.

In some embodiments, the controller generates a predicted battery level value according to a battery cycle count, the battery voltage, the battery temperature, the second battery level difference, and the second battery level.

In this embodiment, the controller may calibrate the second battery level according to the battery cycle count, the battery voltage, the battery temperature, and the second battery level difference to obtain the predicted battery level value.

In some embodiments, the controller determines a battery level calibration coefficient according to the battery voltage, the battery temperature, the battery cycle count, and the second battery level difference, and generates the predicted battery level value according to the battery level calibration coefficient and the second battery level.

In this embodiment, the battery level calibration coefficient is a coefficient used to calibrate the second battery level. It may be understood that because the battery cycle count, the battery voltage, the battery temperature, and the second battery level difference are two different prediction dimensions, when determining the battery level calibration coefficient, the controller needs to distinguish between different prediction dimensions, thereby improving accuracy and reliability of the battery level calibration coefficient.

In some embodiments, the controller determines a first calibration coefficient according to the battery voltage, the battery temperature, and the battery cycle count, determines a second calibration coefficient according to the second battery level difference, and determines the battery level calibration coefficient according to the first calibration coefficient and the second calibration coefficient.

In this embodiment, because the battery voltage, the battery temperature, and the battery cycle count are different prediction indicators for predicting the battery level, when determining the first calibration coefficient, the controller may first standardize the different prediction indicators to eliminate differences between the different prediction indicators, to facilitate comprehensive prediction of a plurality of different prediction indicators together, thereby facilitating prediction of the battery level.

In some embodiments, the controller may normalize the battery voltage, the battery temperature, and the battery cycle count respectively to obtain a normalized voltage value, a normalized temperature value, and a normalized count value, calculate a weighted value according to the normalized voltage value, a first weight coefficient, the normalized temperature value, a second weight coefficient, the normalized count value, and a third weight coefficient, and determine the first calibration coefficient according to the weighted value.

For example, the controller may normalize the battery voltage, the battery temperature, and the battery cycle count respectively by using a normalization model such as a Sigmoid model, a Min-MaX model, a Z-Score model, or a Log model to obtain a normalized voltage value $Vo$, a normalized temperature value $Te$, and a normalized count value $Ti$, and calculate a weighted value according to the following formula:

$$\alpha_0 = Vo * \alpha_1 + Te * \alpha_2 + Ti * \alpha_3$$

where $\alpha_0$ is the weighted value, Vo is the normalized voltage value, $\alpha_1$ is the first weight coefficient, Te is the normalized temperature value, $\alpha_2$ is the second weight coefficient, Ti is the normalized count value, and $\alpha_3$ is the third weight coefficient.

When determining the first calibration coefficient, the controller may calculate the first calibration coefficient according to the weighted value by using any suitable algorithm. Alternatively, the controller may search a preset configuration table according to the weighted value. In the preset configuration table, a correspondence between the weighted value and a calibration coefficient is configured. The controller may use a calibration coefficient corresponding to the weighted value in the preset configuration table as the first calibration coefficient.

Therefore, on one hand, in this embodiment, the battery voltage, the battery temperature, and the battery cycle count are normalized respectively, so that standards can be unified and differences between the battery voltage, the battery temperature, and the battery cycle count can be eliminated, thereby facilitating comprehensive prediction of the battery voltage, the battery temperature, and the battery cycle count together, and facilitating prediction of the battery level. On the other hand, in this embodiment, weighted summation is performed on the normalized values corresponding to the battery voltage, the battery temperature, and the battery cycle count in consideration of different contributions of the battery voltage, the battery temperature, and the battery cycle count to the prediction of the battery level. In this way, the respective contributions of the battery voltage, the battery temperature, and the battery cycle count to the prediction of the battery level can be highlighted.

When determining the second calibration coefficient, the controller may calculate the second calibration coefficient according to the second battery level difference by using any suitable algorithm. Alternatively, the controller may search the preset configuration table according to the second battery level difference. In the preset configuration table, a correspondence between the second battery level difference and a calibration coefficient is further configured. The controller may use a calibration coefficient corresponding to the second battery level difference in the preset configuration table as the first calibration coefficient.

Because the first calibration coefficient and the second calibration coefficient are calibration coefficients calculated respectively according to two different prediction dimensions, the two calibration coefficients may have different impact degrees on battery level prediction. Therefore, the controller may highlight respective impact degrees by configuring corresponding weight coefficients for the two calibration coefficients.

In some embodiments, the first calibration coefficient corresponds to a fourth weight coefficient, the second calibration coefficient corresponds to a fifth weight coefficient, and the controller may calculate the battery level calibration coefficient according to the following formula:

$$C = c_1 * \alpha_4 + c_2 * \alpha_5$$

where C is the battery level calibration coefficient, c1 is the first calibration coefficient, $\alpha_4$ is the fourth weight coefficient, c2 is the second calibration coefficient, and $\alpha_5$ is the fifth weight coefficient.

The fourth weight coefficient and the fifth weight coefficient are preconfigured. Therefore, if the fixed fourth weight coefficient and fifth weight coefficient are used to calculate the battery level calibration coefficient, there may be a deviation from an actual situation. Therefore, the controller may interfere with the fourth weight coefficient and the fifth weight coefficient according to the actual situation, thereby helping improve accuracy and reliability of the battery level calibration coefficient.

In some embodiments, the controller may calculate a coefficient difference between the first calibration coefficient and the second calibration coefficient, determine a correction factor according to the coefficient difference, correct the fourth weight coefficient and the fifth weight coefficient according to the correction factor to obtain a corrected fourth weight coefficient and a corrected fifth weight coefficient, and determine the battery level calibration coefficient according to the first calibration coefficient, the corrected fourth weight coefficient, the second calibration coefficient, and the corrected fifth weight coefficient.

For example, the controller subtracts the second calibration coefficient from the first calibration coefficient to obtain the coefficient difference. Next, the controller may calculate the correction factor according to the coefficient difference by using any suitable algorithm. Alternatively, the controller may search a preset configuration table according to the coefficient difference. In the preset configuration table, a correspondence between the coefficient difference and a factor is further configured. The controller may use the factor corresponding to the coefficient difference in the preset configuration table as the correction factor. It may be understood that the correction factor may be a positive value or a negative value. When correcting the fourth weight coefficient and the fifth weight coefficient, the controller may add the correction factor to the fourth weight coefficient, and use the sum as the corrected fourth weight coefficient, and meanwhile, the controller may subtract the correction factor from the fifth weight coefficient, and use the difference as the corrected fifth weight coefficient.

In some embodiments, the controller may further calculate the battery level calibration coefficient according to the following formula:

$$C = c_1 * \alpha_{44} + c_2 * \alpha_{55}$$

where C is the battery level calibration coefficient, c1 is the first calibration coefficient, $\alpha 44$ is the corrected fourth weight coefficient, c2 is the second calibration coefficient, and $\alpha 55$ is the corrected fifth weight coefficient.

In some embodiments, the controller may calculate the predicted battery level value according to the following formula:

$$BAT = C * BAT_2$$

where BAT is the predicted battery level value, C is the battery level calibration coefficient, and BAT2 is the second battery level.

It should be noted that, in the foregoing implementations, the foregoing steps are not necessarily performed in a particular order. A person of ordinary skill in the art may understand according to the descriptions of the implementations of the present invention that, in different implementations, the foregoing steps may be performed in different orders, that is, the steps may be performed in parallel, or may be performed interchangeably, or the like.

An embodiment of the present invention provides a battery level verification apparatus. The battery level verification apparatus may be a software module. The software module includes several instructions that are stored in a memory. The processor may access the memory and call the instructions for execution, to implement the battery level verification method described in the foregoing implementations.

In some embodiments, the battery level verification apparatus may be built by hardware devices. For example, the battery level verification apparatus may be built by one or two or more chips, and the chips may work in coordination with each other, to complete the battery level verification method described in the foregoing implementations. For another example, the battery level verification apparatus may be further built by various logic devices, such as a general-purpose processor, a digital signal processor (DSP), an application-specific integrated circuit (ASIC), a field programmable gate array (FPGA), a single-chip machine, an Acorn RISC machine (ARM), or another programmable logic device (PLD), a discrete gate or transistor logic, a discrete hardware component, or any combination of these components.

Referring to FIG. 5, a battery level verification apparatus 500 includes an obtaining module 51, a first determining module 52, a first generation module 53, a control module 54, and a second generation module 55.

The obtaining module 51 is configured to obtain battery sampling data and a first battery level, the battery sampling data being collected by a battery sampling module from a battery, and the first battery level being calculated by a coulometer in a non-reset state according to the battery sampling data. The first determining module 52 is configured to determine a target battery level according to the battery sampling data. The first generation module 53 is configured to generate first battery level verification information according to the target battery level and the first battery level. The control module 54 is configured to control, if the first battery level verification information is used to indicate that the first battery level is unreliable, the coulometer to perform a reset operation, so that the coulometer calculates, in a reset state, a second battery level of the battery according to the battery sampling data. The second generation module 55 is configured to generate second battery level verification information according to the second battery level and the target battery level.

In some embodiments, referring to FIG. 6, the first determining module 52 includes a judging unit 521 and a first determining unit 522.

The judging unit 521 is configured to determine whether a battery current is stable within a target current interval. The first determining unit 522 is configured to determine the target battery level according to battery status parameters when the battery current is stable within the target current interval.

In some embodiments, the judging unit 521 is specifically configured to: determine whether the battery current is greater than a first preset current threshold and lasts for first preset duration; if the battery current is greater than the first preset current threshold and lasts for the first preset duration, determine that the battery current is stable in a first current interval; if the battery current is greater than the first preset threshold and does not lasts for the first preset duration, or is less than or equal to the first preset threshold, determine whether the battery current is less than or equal to the first preset current threshold and greater than a second preset current threshold, and lasts for second preset duration; and if the battery current is less than or equal to the first preset current threshold and greater than the second preset current threshold, and lasts for the second preset duration, determine that the battery current is stable in a second current interval.

In some embodiments, the first determining unit 522 is specifically configured to: determine a target database corresponding to the target current interval in a plurality of preset databases, and find a corresponding reference battery level in the target database according to the battery status parameters as the target battery level.

In some embodiments, referring to FIG. 7, the first generation module 53 includes a first calculation unit 531 and a first generation unit 532.

The first calculation unit 531 is configured to calculate a first battery level difference between the first battery level and the target battery level. The first generation unit 532 is configured to generate the first battery level verification information according to the first battery level difference and a first preset battery level threshold.

In some embodiments, referring to FIG. 6, the second generation module 55 includes a second calculation unit 551 and a second generation unit 552.

The second calculation unit 551 is configured to calculate a second battery level difference between the second battery level and the target battery level. The second generation unit 552 is configured to generate the second battery level verification information according to the second battery level difference and a second preset battery level threshold.

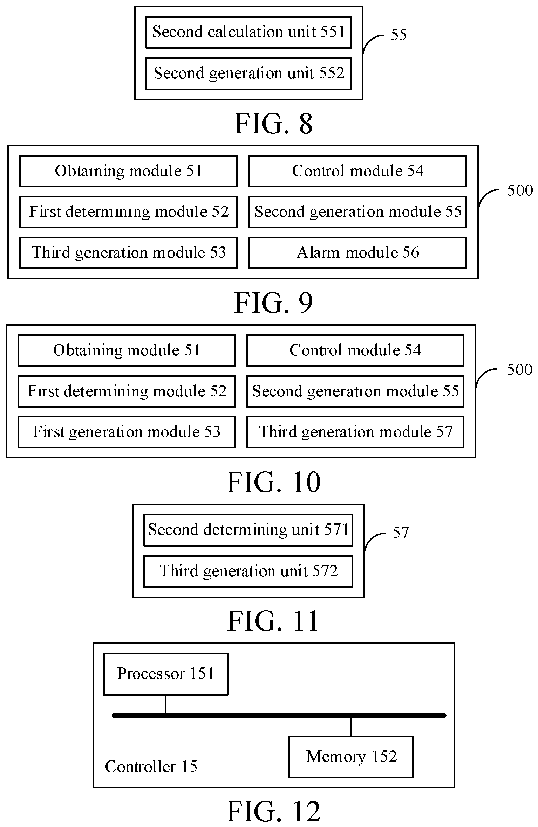

In some embodiments, referring to FIG. 9, the battery level verification apparatus 500 further includes an alarm module 56.

The alarm module 56 is configured to generate an alarm signal if the second battery level verification information is used to indicate that the second battery level is unreliable.

In some embodiments, referring to FIG. 10, the battery level verification apparatus 500 further includes a third generation module 57.

The third generation module 57 is configured to generate a predicted battery level value according to a battery cycle count, a battery voltage, a battery temperature, the second battery level difference, and the second battery level.

In some embodiments, referring to FIG. 11, the third generation module 57 includes a second determining unit 571 and a third generation unit 572.

The second determining unit 571 is configured to determine a battery level calibration coefficient according to the battery voltage, the battery temperature, the battery cycle count, and the second battery level difference. The third generation unit 572 is configured to generate the predicted battery level value according to the battery level calibration coefficient and the second battery level.

In some embodiments, the second determining unit 571 is configured to determine a first calibration coefficient according to the battery voltage, the battery temperature, and the battery cycle count, determine a second calibration coefficient according to the second battery level difference, and determine the battery level calibration coefficient according to the first calibration coefficient and the second calibration coefficient.

It should be noted that, the foregoing battery level verification apparatus can perform the battery level verification method provided in the implementations of the present invention, and has corresponding functional modules and beneficial effects for performing the method. For technical details that are not elaborated in the implementations of the battery level verification apparatus, refer to the battery level verification method provided in the implementations of the present invention.

Referring to FIG. 12, FIG. 12 is a schematic diagram of a hardware structure of a controller according to an embodiment of the present invention. As shown in FIG. 12, the controller 15 includes one or more processors 151 and a memory 152. In FIG. 12, one processor 151 is used as an example.

The processor 151 is configured to support the controller to perform a corresponding function in the method in the foregoing method embodiments. The processor 151 may be a central processing unit (CPU), a network processor (NP), a hardware chip, or any combination thereof. The hardware chip may be an ASIC, a PLD, or a combination thereof. The PLD may be a complex PLD (CPLD), an FPGA, generic array logic (GAL), or any combination thereof.

The memory 152 is configured to store program code and the like. The memory 152 may include a volatile memory (VM), such as a random access memory (RAM); or the memory may include a non-volatile memory (NVM), such as a read-only memory (ROM), a flash memory, a hard disk drive (HDD), or a solid-state drive (SSD); or the memory 152 may include a combination of the foregoing types of memories.

The memory 152 may be configured to store a non-volatile software program, a non-volatile computer executable program, and a module, for example, a program instruction/module corresponding to the battery level verification method in the embodiments of the present invention. The processor 151 runs the non-volatile software program, instruction, and module stored in the memory 152, to perform various functional applications and data processing of the battery level verification method and the battery level verification apparatus, that is, implement functions of modules or units of the battery level verification method and the battery level verification apparatus that are provided in the foregoing method embodiments.

The memory 152 may include a program storage area and a data storage area. The program storage area may store an operating system and an application program required by at least one function. The data storage area may store data created according to use of the battery level verification apparatus, and the like. In some embodiments, the memory 152 may optionally include memories remotely disposed relative to the processor, and the remote memories may be connected to the battery level verification apparatus through a network. Examples of the network include, but are not

**EP 4 667 955 A1**

limited to, the Internet, an intranet, a local area network, a mobile communication network, and a combination thereof.

The one or more modules are stored in the memory 152, and when being executed by the one or more processors 151, perform the battery level verification method in any one of the foregoing method embodiments, for example, perform method steps described in the foregoing method embodiments, and implement functions of the modules described in the foregoing apparatus embodiments.

An embodiment of the present invention further provides a computer-readable storage medium. The computer-readable storage medium stores a computer program. The computer program includes program instructions. When the program instructions are executed by a computer, the computer is caused to perform the method described in the foregoing embodiments.

A person of ordinary skill in the art may understand that all or some of the procedures of the methods in the foregoing embodiments may be implemented by a computer program instructing relevant hardware. The program may be stored in a computer-readable storage medium. When the program is executed, the procedures of the foregoing method embodiments may be performed. The storage medium may be a magnetic disk, an optical disc, a ROM, a RAM, or the like.

Finally, it should be noted that the present invention may be implemented in many different forms, and is not limited to the embodiments described in this specification. These embodiments are not intended to additionally limit the content of the present invention, and the implementations are provided to make the understanding of the disclosure of the present invention more thorough and comprehensive. In addition, under the concept of the present invention, the foregoing technical features continue to be combined with each other, and many other variations in different aspects of the present invention as described above exist, which all fall within the scope described in the specification of the present invention. Further, for a person of ordinary skill in the art, improvements or modifications may be made according to the above descriptions, and all these improvements and modifications shall fall within the protection scope of the appended claims of the present invention.

**Claims**

1. A battery level verification method, applied to a battery apparatus, wherein the battery apparatus comprises a battery, a battery sampling module, a coulometer, and a controller, the battery sampling module being electrically connected to the battery and the coulometer separately, and the coulometer being further electrically connected to the controller, and the method comprises:

   obtaining battery sampling data and a first battery level, the battery sampling data being collected by the battery sampling module from the battery, and the first battery level being calculated by the coulometer in a non-reset state according to the battery sampling data;
   determining a target battery level according to the battery sampling data;
   generating first battery level verification information according to the target battery level and the first battery level;
   controlling, if the first battery level verification information is used to indicate that the first battery level is unreliable, the coulometer to perform a reset operation, so that the coulometer calculates, in a reset state, a second battery level of the battery according to the battery sampling data; and
   generating second battery level verification information according to the second battery level and the target battery level.

2. The battery level verification method according to claim 1, wherein the battery sampling data comprises a battery current and battery status parameters, and the determining a target battery level according to the battery sampling data comprises:

   determining whether the battery current is stable within a target current interval; and
   determining the target battery level according to the battery status parameters if the battery current is stable within the target current interval.

3. The battery level verification method according to claim 2, wherein the target current interval is one of at least two current intervals, different current intervals correspond to different preset databases, and the determining the target battery level according to the battery status parameters comprises:

   determining a target database corresponding to the target current interval in a plurality of preset databases; and
   finding a corresponding reference battery level in the target database according to the battery status parameters as the target battery level.

14

4. The battery level verification method according to claim 1, wherein the generating first battery level verification information according to the target battery level and the first battery level comprises:

calculating a first battery level difference between the first battery level and the target battery level; and generating the first battery level verification information according to the first battery level difference and a first preset battery level threshold.

5. The battery level verification method according to claim 1, wherein the generating second battery level verification information according to the second battery level and the target battery level comprises:

calculating a second battery level difference between the second battery level and the target battery level; and generating the second battery level verification information according to the second battery level difference and a second preset battery level threshold.

6. The battery level verification method according to claim 5, wherein the battery status parameters comprise a battery voltage and a battery temperature, and the method further comprises:

generating an alarm signal if the second battery level verification information is used to indicate that the second battery level is unreliable; or generating a predicted battery level value according to a battery cycle count, the battery voltage, the battery temperature, the second battery level difference, and the second battery level.

7. The battery level verification method according to claim 6, wherein the generating a predicted battery level value according to a battery cycle count, the battery voltage, the battery temperature, the second battery level difference, and the second battery level comprises:

determining a battery level calibration coefficient according to the battery voltage, the battery temperature, the battery cycle count, and the second battery level difference; and generating the predicted battery level value according to the battery level calibration coefficient and the second battery level.

8. The battery level verification method according to claim 7, wherein the determining a battery level calibration coefficient according to the battery voltage, the battery temperature, the battery cycle count, and the second battery level difference comprises:

determining a first calibration coefficient according to the battery voltage, the battery temperature, and the battery cycle count; determining a second calibration coefficient according to the second battery level difference; and determining the battery level calibration coefficient according to the first calibration coefficient and the second calibration coefficient.

9. The battery level verification method according to claim 8, wherein the determining a first calibration coefficient according to the battery voltage, the battery temperature, and the battery cycle count comprises:

normalizing the battery voltage, the battery temperature, and the battery cycle count respectively to obtain a normalized voltage value, a normalized temperature value, and a normalized count value; calculating a weighted value according to the normalized voltage value, a first weight coefficient, the normalized temperature value, a second weight coefficient, the normalized count value, and a third weight coefficient; and determining the first calibration coefficient according to the weighted value.

10. The battery level verification method according to claim 8, wherein the first calibration coefficient corresponds to a fourth weight coefficient, the second calibration coefficient corresponds to a fifth weight coefficient, and the determining the battery level calibration coefficient according to the first calibration coefficient and the second calibration coefficient comprises:

calculating a coefficient difference between the first calibration coefficient and the second calibration coefficient; determining a correction factor according to the coefficient difference; correcting the fourth weight coefficient and the fifth weight coefficient according to the correction factor to obtain a corrected fourth weight coefficient and a corrected fifth weight coefficient; and
determining the battery level calibration coefficient according to the first calibration coefficient, the corrected fourth weight coefficient, the second calibration coefficient, and the corrected fifth weight coefficient.

11. A controller, comprising:

at least one processor; and
a memory communicatively connected to the at least one processor, wherein
the memory stores instructions executable by the at least one processor, and the instructions are executed by the at least one processor to enable the at least one processor to perform the battery level verification method according to any one of claims 1 to 10.

12. A battery apparatus, comprising:

a battery;
a battery sampling module, electrically connected to the battery and configured to sample battery data of the battery;
a coulometer, electrically connected to the battery sampling module and configured to calculate a battery level of the battery according to the battery data; and
the controller according to claim 11, wherein the controller is electrically connected to the coulometer.

13. A drone, comprising the battery apparatus according to claim 12.

FIG. 1

Obtain battery sampling data and a first battery level — S21

Determine a target battery level according to the battery sampling data — S22

Generate first battery level verification information according to the target battery level and the first battery level — S23

Control, if the first battery level verification information is used to indicate that the first battery level is unreliable, a coulometer to perform a reset operation, so that the coulometer calculates, in a reset state, a second battery level of a battery according to battery status parameters — S24

Generate second battery level verification information according to the second battery level and the target battery level — S25

## FIG. 2

S22

Determine whether a battery current is stable within a target current interval — S221

Yes

Determine the target battery level according to battery status parameters — S222

## FIG. 3

S221

Determine whether the battery current is stable in a first current interval and greater than a first preset current threshold and lasts for first preset duration

S2211

No

Yes

Determine that the battery current is stable in the first current interval

S2211

Determine whether the battery current is less than or equal to the first preset current threshold and greater than a second preset current threshold, and lasts for second preset duration

S2213

Determine that the battery current is stable in a second current interval

S2214

**FIG. 4**

| Obtaining module 51 | Control module 54 |
|---|---|
| First determining module 52 | Second generation module 55 |
| First generation module 53 | |

500

**FIG. 5**

| Judging unit 521 |
|---|
| First determining unit 522 |

52

**FIG. 6**

| First calculation unit 531 |
|---|
| First generation unit 532 |

53

**FIG. 7**

Second calculation unit 551 — 55

Second generation unit 552

FIG. 8

| | |
|---|---|
| Obtaining module 51 | Control module 54 |
| First determining module 52 | Second generation module 55 |
| Third generation module 53 | Alarm module 56 |

— 500

FIG. 9

| | |
|---|---|
| Obtaining module 51 | Control module 54 |
| First determining module 52 | Second generation module 55 |
| First generation module 53 | Third generation module 57 |

— 500

FIG. 10

Second determining unit 571 — 57

Third generation unit 572

FIG. 11

Processor 151

Controller 15            Memory 152

FIG. 12

Europäisches
Patentamt

European
Patent Office

Office européen
des brevets

# EUROPEAN SEARCH REPORT

**Application Number**

**EP 25 18 1399**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/252775 A1 (WU JUI-CHI [TW] ET AL) 6 September 2018 (2018-09-06) | 1-5, 11-13 | INV.<br>G01R31/367 |
| Y | * paragraphs [0002], [0021] - [0027]; figure 1 * | 6-10 | G01R31/3828<br>G01R31/3842<br>G01R31/388 |
| | ----- | | |
| Y | US 2005/038614 A1 (BOTTS STEVE [US] ET AL) 17 February 2005 (2005-02-17) | 6-10 | |
| A | * paragraphs [0047] - [0049], [0055], [0056] * | 1-5 | |
| | ----- | | |
| A | CN 117 289 158 A (WEICHAI NEW ENERGY POWER TECH CO LTD) 26 December 2023 (2023-12-26) * paragraphs [0068] - [0073] * | 1-13 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 9 November 2025 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 1399

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2025

| Patent document cited in search report | | | Publication date | Patent family member(s) | | | Publication date |
|---|---|---|---|---|---|---|---|
| US 2018252775 | A1 | | 06-09-2018 | CN | 108535651 | A | 14-09-2018 |
| | | | | TW | 201834348 | A | 16-09-2018 |
| | | | | US | 2018252775 | A1 | 06-09-2018 |
| US 2005038614 | A1 | | 17-02-2005 | AU | 2002365581 | A1 | 10-06-2003 |
| | | | | CA | 2504006 | A1 | 05-06-2003 |
| | | | | EP | 1461629 | A2 | 29-09-2004 |
| | | | | US | 2005038614 | A1 | 17-02-2005 |
| | | | | WO | 03047064 | A2 | 05-06-2003 |
| CN 117289158 | A | | 26-12-2023 | NONE | | | |

EPO FORM P0459

For more details about this annex : see Official Journal of the European Patent Office, No. 12/82